# EUROPEAN PATENT APPLICATION

(11) **EP 3 968 457 A1**
(43) Date of publication of application: **16.03.2022**
(21) Application number: 21195585.1
(22) Date of filing: 08.09.2021
(51) Int. Cl.: H01Q 1/32, H01Q 1/02, H05K 7/20

(54) **VEHICLE-BODY ANTENNA MODULE AND METHOD FOR COOLING A VEHICLE-BODY ANTENNA MODULE**

(30) Priority: 09.09.2020 DE 102020123549
(71) Applicant: Hirschmann Car Communication GmbH, 72654 Neckartenzlingen (DE)
(72) Inventor: BOEHMERT, Roland, 72654 Neckartenzlingen (DE); SCHAICH, Dominik, 72654 Neckartenzlingen (DE); DAUM, Uwe, 72654 Neckartenzlingen (DE); ADAM, Thomas, 72654 Neckartenzlingen (DE); PFLETSCHINGER, Markus, 72654 Neckartenzlingen (DE)
(74) Representative: Patentanwaltskanzlei WILHELM & BECK

(57) **Abstract**

The invention relates to a vehicle-body antenna module (10), in particular 5G antenna module (10), for a vehicle, in particular a motor vehicle, comprising at least: a lower housing (100), a telematics unit (200), and an antenna support (400), wherein the antenna module (10) extending primarily in a transverse direction (Qr) is configured in such a way that a telematics printed circuit board (202) of the telematics unit (200) is actively coolable, wherein a first section (214) of the telematics unit (200) or the telematics printed circuit board (202) is coolable by a forced airflow, and a second section (224) of the telematics unit (200) or the telematics printed circuit board (202) is coolable by a Peltier element (222).

## Description

The present invention relates to a vehicle-body antenna module, in particular a 5G antenna module, for a vehicle, in particular a motor vehicle. Furthermore, the present invention relates to a method for cooling a vehicle-body antenna module, in particular a 5G antenna module. In addition, the present invention relates to a vehicle body and a vehicle.

DE 10 2016 123 868 A1 (US 10 135 110 B2) discloses an external vehicle body roof antenna module which is mountable on a roof of a vehicle and which has a cooling system. The cooling system comprises a battery and a Peltier cooling element which can be supplied with electrical current by the battery. An antenna and electronics of the antenna module belonging to the antenna are arranged on a cold side of the Peltier cooling element. The antenna is designed to radiate a signal from the electronics or to receive a radiated signal from another communication device.

The automobile industry will equip the new generations of motor vehicles with 5G technology. For the high frequencies thereof, it is expedient to put a NAD (network access device) transceiver close to an antenna module in order to avoid cable losses. - External or integrated roof antenna modules demonstrate good high-frequency performance, with the disadvantage of possibly high temperatures when exposed to sunlight, wherein the temperature-sensitive transceivers will be integrated into such hot areas in the future. The temperature below/in a vehicle roof is up to 105°C. The typical operating temperature range of a transceiver is from -40°C to +85°C (above +85°C, the SAW filters of the NAD transceiver can usually no longer be used, because they lose their effectiveness or operate outside a specification). - It is therefore an object of the present invention to specify an improved external and/or integrated vehicle-body antenna module for a vehicle, in particular a motor vehicle.

The object of the present invention is achieved by means of a vehicle-body antenna module, in particular a 5G antenna module, for a vehicle, in particular a motor vehicle, by a method for cooling a vehicle-body antenna module, in particular a 5G antenna module, and by means of a vehicle body and a vehicle. - Advantageous refinements, additional features, and/or advantages of the present invention result from the dependent claims and the following description.

In order for a NAD transceiver of an antenna module to be able to function in such a hot environment, active cooling is necessary. Other components such as a power supply, an amplifier, a CPU, an Ethernet device, Wi-Fi, GNSS, SDARS, etc. can operate at higher temperatures (junction temperature) up to 125°C. An additional challenge is that the space available to the entire intelligent antenna module is limited. Here, a thermal short circuit between different critical temperature ranges must be avoided. Thus, it must be possible to manage high temperature differences in a small area.

The vehicle-body antenna module according to the present invention comprises at least: a lower housing, a telematics unit, and an antenna support, for example, an antenna printed circuit board, and the antenna module extending primarily in a transverse direction is configured in such a way that a telematics printed circuit board of the telematics unit is actively coolable, wherein a first section of the telematics unit or the telematics printed circuit board is coolable by a forced airflow, and a second section of the telematics unit or the telematics printed circuit board is coolable by a Peltier element.

The term 'vehicle-body antenna module' is intended to express that this antenna module is configured for attachment and/or installation on and/or in a section of a vehicle body, in particular at least one vehicle body part, a rear vehicle body, at least one rear body part, a (rear) vehicle roof, etc., of a vehicle, in particular a motor vehicle. Here, the antenna module may be configured as an external antenna module (i.e. mountable externally on the vehicle body) and/or in particular as an integrated antenna module (i.e. mountable internally in/on the vehicle body, for example, beneath an outer skin, a cover, etc.). Of course, a hybrid form thereof may be used.

The first section may be configured as a non-NAD area, and the second section may be configured as a NAD area, of the telematics printed circuit board. The telematics printed circuit board may comprise a thermal barrier arrangement between the NAD area and the non-NAD area for decoupling a mutual heat exchange. The thermal barrier arrangement is intended, in particular, to prevent a heat influx from the non-NAD area into the NAD area of the telematics printed circuit board. The thermal barrier arrangement may be arranged, for example, as a through-slit, a reduced cross-section, a reduction of a ground conductor, a local reduction of an occurrence of a metal, in particular copper, etc., in the telematics printed circuit board.

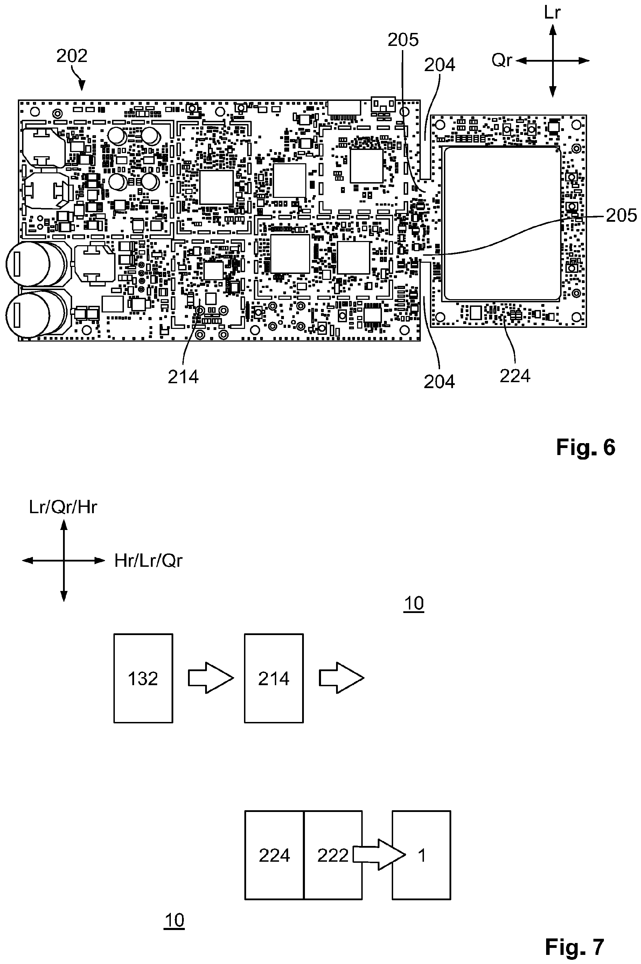

The NAD area of the telematics printed circuit board is the area in which the NAD (network access device) and possibly its peripherals (see Figure 6) are arranged. In particular, this may be a specific end section of the telematics printed circuit board. Accordingly, the non-NAD area is the area of the telematics printed circuit board which is away from the NAD and possibly its peripherals. Furthermore, alternatively or in addition, the NAD area may be configured and/or designated as a thermally critical area, and the non-NAD area may be configured and/or designated as a thermally less critical area, of the telematics printed circuit board.

In one embodiment, a thermal barrier arrangement comprises two through-slits in the telematics printed circuit board, which preferably divide the telematics printed circuit board into a head (comparatively small with respect to the torso), a neck (narrow point between the head and the torso), and a torso(comparatively large with respect to the head). The through-slits are preferably arranged essentially symmetrically, in particular mirror-symmetrically, in the telematics printed circuit board, wherein the head, neck, and torso thereof are also preferably arranged symmetrically, in particular mirror-symmetrically, in the telematics printed circuit board. Preferably, a corresponding central transverse direction of the telematics printed circuit board is the mirror axis.

The antenna module may be configured in such a way that a body of the vehicle, or the (entire) vehicle, acts as a substantial heat sink for the antenna module. 'Substantial heat sink' is intended to be understood to be the only intended heat sink, apart from forced heat transport by means of a fan (see below) and other dissipation by the antenna module. The antenna module may be configured in such a way that heat from the telematics unit can be transferred to the/a vehicle body via its lower housing. The lower housing is fabricated, in particular, from a good heat conductor, in particular from metal, preferably aluminium.

The antenna module may comprise a fan in a transverse end section, wherein the airflow which is forceable by said fan is directed at least onto the first section of the telematics printed circuit board. Preferably, the fan is configured as a centrifugal fan. The fan may blow or suck the forced airflow across the telematics printed circuit board, possibly also laterally and/or past the bottom, or through the antenna module. In addition or alternatively, the antenna module is also fluid-mechanically connectable to an air conditioning system of the vehicle.

The telematics unit may comprise two areas which adjoin one another, preferably in the transverse direction. Here, the first area of the telematics unit may correspond to the/a non-NAD area of the telematics printed circuit board. Furthermore, the second area of the telematics unit may comprise a cooling package in which the/a NAD area of the telematics printed circuit board is arranged to be coolable. In addition, at least one area or both areas of the telematics unit may be in heat-transfer contact with the lower housing. For this purpose, a heat-transfer device, for example, a thermally conductive pad, a thermally conductive paste, thermally conductive gel, etc., may be arranged between the lower housing and the corresponding area.

The second section of the telematics printed circuit board may be arranged in the/a cooling package of the telematics unit. Furthermore, the cooling package may comprise the Peltier element, the NAD area of the telematics printed circuit board, and preferably, a cooling package cover. The cooling package cover may be made of a metal, in particular aluminium, and/or a plastic. The cooling package may further comprise an accommodation frame in which the Peltier element and the NAD area may be accommodated, wherein the accommodation frame is preferably closable by the cooling package cover. The accommodation frame may be made of metal, in particular aluminium, or plastic.

The NAD area may be in heat-transfer contact with a cold side of the Peltier element. Of course, the cold side of the Peltier element depends on a current flow through the Peltier element, i.e. the Peltier element is to be actuated for cooling in such a way that its cold side is established here (NAD area). If the NAD area is to be heated, for example, in the case of very cold outside temperatures, this is of course possible by reversing the current flow (see below). The heat-transfer contact may be established by means of a heat-transfer device, for example, a thermally conductive pad, a thermally conductive paste, a thermally conductive gel, a solder, etc. - The cooling package may have a sandwich structure, in which the package components thereof are arranged stacked in the vertical direction of the antenna module. Furthermore, the airflow which is forceable by the fan may be further directed to the cooling package of the telematics unit. The airflow is to flow past the cooling package, in particular below it and/or at the side.

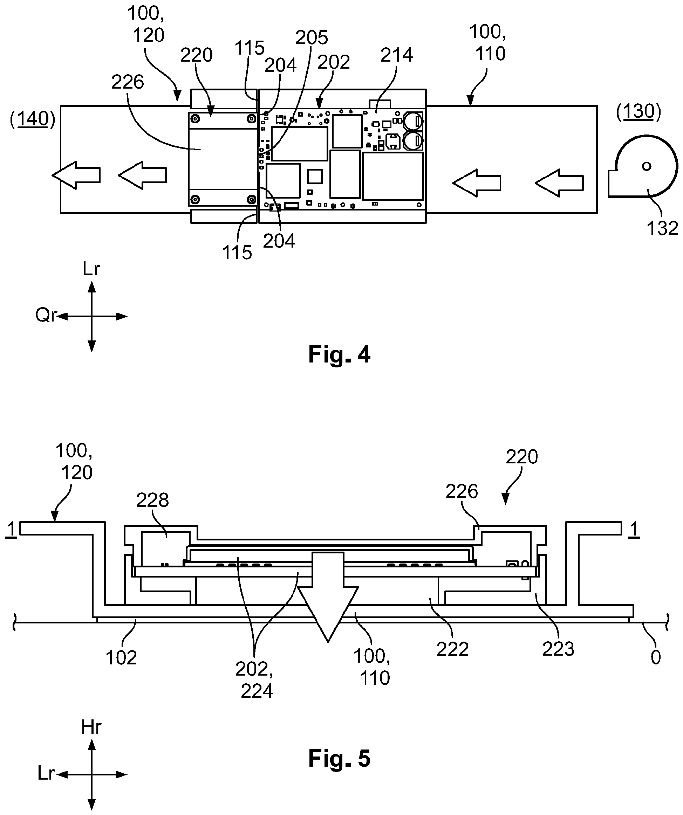

The cooling package may be configured as a kind of 'refrigerator' or cooling box (see also Figure 5). The Peltier element forms the rear wall of the refrigerator having a warm outer surface (this heat is essentially transferred to the vehicle body via the lower housing (second base plate (see below)) and a cooling inner side (cooling space) during the operation of the Peltier element. The accommodation frame, possibly together with a frame of the cooling package cover, forms a circumferential outer wall of the refrigerator, wherein furthermore, the cooling package cover functions as a closed refrigerator door, and closes off a cooling space of the refrigerator opposite to the cooling inner side of the Peltier element. By means of this measure, the NAD of the NAD area, or the NAD area, is thermally insulated and decoupled from the forced airflow. The cooling package does not have to be either liquid-tight or gas-tight.

The lower housing may comprise at least one or exactly one base plate. Here, a first section, in particular a transverse section, of the base plate may be in heat-transfer contact with the non-NAD area. Furthermore, a second section, in particular a transverse section, of the base plate may be in heat-transfer contact with the cooling package, in particular a hot side of the Peltier element. For decoupling a mutual heat exchange, the base plate may comprise a thermal barrier arrangement between its first section and its second section. The thermal barrier arrangement is intended to prevent a thermal short circuit, i.e. a heat exchange between the base plate sections, at least partially or essentially.

The thermal barrier arrangement is intended, in particular, to prevent heat influx from the first section into the second section of the base plate. The thermal barrier arrangement may be configured, for example, as a through-slit, a reduced cross section, etc., in the base plate. Furthermore, the two sections may be connected to one another via a thermal insulator, to form one, or a single, base plate.

The lower housing may comprise at least or exactly two bottom plates. The first base plate may be in heat-transfer contact with the non-NAD area. Furthermore, the second base plate may be in heat-transfer contact with the cooling package, in particular a hot side of the Peltier element. The respective heat-transfer contact may be configured by means of a heat-transfer device, for example, a thermally conductive pad, a thermally conductive paste, a thermally conductive gel, etc., (this also applies analogously to the above single base plate). Preferably, the bottom plates are fabricated from a metal, in particular aluminium, (this again applies analogously to the above single base plate). - The hot side of the Peltier element of course depends on a current flow through the Peltier element, i.e. the Peltier element is to be actuated for cooling in such a way that its hot side is arranged here (single or second base plate).

For decoupling a mutual heat exchange, the two bottom plates, or the two thermally decoupled parts of a single base plate, are arranged spaced apart from one other in the antenna module, preferably via a thermal barrier arrangement, in particular a thermal barrier slit. It is preferred that the thermal barrier arrangement of the telematics printed circuit board and the thermal barrier slit between the two base plates at least overlap when viewed in the transverse direction, or that the one is inside the other or they essentially align with one another when viewed in the vertical direction.

At least one or one respective antenna support may be arranged on the first and/or second base plate. By means of an internal arrangement of the components of the antenna module, for example, with at least one separate antenna support, flexibility is provided, and it is possible to adjust a single antenna support quickly to a changing requirement (installation space, extended frequency range, etc.), without necessarily having to modify the telematics printed circuit board or another antenna support, for example, an antenna printed circuit board. Advantageously, the antenna supports utilize a maximum available height of the antenna module in order to achieve a highest possible efficiency. That is, apart from an upper housing and possibly a base plate and/or possibly a lower housing, the antenna support takes up essentially the full height in at least one area inside the antenna module.

The airflow which is forceable by the fan may furthermore be directed onto the at least one antenna support. The lower housing may comprise a side end portion in a transverse end section, on which the fan is mounted. Preferably, said side end portion comprises an air intake for the fan, wherein the fan may be mounted directly above the air intake. Preferably, this side end portion is fabricated from a plastic. - In a transverse end section, the lower housing may comprise a side end portion which comprises an air outlet. The air outlet is used for transporting heated air out of the antenna module. Preferably, this side end portion is also fabricated from a plastic.

In one embodiment, cooling air may be directed by the fan from one transverse end section to the other transverse end section of the antenna module in which the air outlet is located, as a function of a geometry of the antenna module. The lateral arrangement of the fan, i.e. in the transverse direction outside, is conducive to achieving a low height of the antenna module. Furthermore, the fan helps other integrated electronics, for example, on an antenna support, for example, an antenna printed circuit board, another printed circuit board (see below), etc., to be coolable via the cooling air. This may also apply to a certain extent to the hot side of the Peltier element, wherein it is preferred that the cooling air is able to flow laterally past the cooling package in the transverse direction. For this purpose, an air gap may be arranged in the transverse direction between the cooling package and, for example, a side wall or a parapet of the second base plate, a housing section of the antenna module, etc.

The lower housing may be configured in such a way that it is connectable to the vehicle body in an areal manner. Thermal coupling surfaces which relate to one another should be as large as possible, wherein a surface pressure can be set between these two coupling surfaces in order to achieve good thermal contact. This may be achieved, for example, by means of a screw connection. For example, a thermally conductive pad, a thermally conductive paste, a thermally conductive gel, etc. may then also be used. The lower housing may further comprise a heat transfer device, in particular a thermally conductive pad, on its outer surface. A thermally conductive paste, a thermally conductive gel, etc. may possibly also be used. - As a result, the heat arising in the antenna module may be dissipated well to the vehicle body and thus the entire vehicle. This heat may then also be dissipated by the vehicle body or the vehicle to the environment, which, in turn, acts as a heat sink. - The antenna module itself is preferably free of a separate heat sink, in particular a separate finned heat sink, i.e. the antenna module preferably does not comprise such a heat sink. Of course, for example, the lower housing or at least a base plate may additionally be configured as a cooler, for example, by means of cooling fins. In particular, a side wall or a parapet, preferably in a transverse direction, is suitable for this purpose. Here, it is further preferred that the cooler or the cooling fins are also coolable by the forced airflow. As a result, furthermore, the air coming from the fan may be better directed, and the heat of the Peltier element may be better transferred.

The antenna module may comprise another printed circuit board between the lower housing, in particular the telematics unit, and an upper housing. The other printed circuit board may be mounted, for example, in the upper housing. A maximum or achievable height of the antenna module is: approximately: 50 mm, 45 mm, 40 mm, 35 mm, 32.5 mm, 30 mm, 27.5 mm, 25 mm, 22.5 mm, 20 mm, 17.5 mm, or 15 mm. - Furthermore, by means of the antenna module, a method according to the present invention for cooling a vehicle-body antenna module, in particular a 5G antenna module, may be carried out.

In the method according to the present invention for cooling, the antenna module comprises a telematics unit comprising a telematics printed circuit board, wherein the telematics unit or the telematics printed circuit board is divided into a non-NAD area and a NAD area, and if a limit temperature is exceeded, the non-NAD area and/or the NAD area are actively cooled, and the non-NAD area and the NAD area can be cooled essentially independently of one another.

This means, for example, that if a first limit temperature is exceeded, essentially only the NAD area or essentially only the non-NAD area may be actively cooled initially. If a second limit temperature is exceeded, in addition, the non-NAD area or the NAD area may also be actively cooled. Of course, it is possible that if a third limit temperature is exceeded, both the non-NAD area and the NAD area are actively cooled. A corresponding cooling system (see above) may remain dormant until the corresponding limit temperature in the antenna module or in an electronic system of the antenna module has been reached.

Here, for example, a maximum temperature of the NAD area is 85°C during operation of the antenna module, so that, for example, a limit temperature therefor may be set to approximately: 75°C, 77.5°C, 80°C, 81 °C, or 82°C. A maximum temperature for the non-operation of the NAD area may be higher, approximately 105°C to 125°C. Correspondingly, a limit temperature is to be selected therefor. - Furthermore, for example, a maximum temperature of the non-NAD area is 125°C during operation of the antenna module, so that, for example, a limit temperature therefor may be set to approximately: 115°C, 117.5°C, 120°C, 121°C, or 122°C.

If a limit temperature is exceeded, the non-NAD area may be cooled by a forced airflow from a fan. If a limit temperature is exceeded, the NAD area may be cooled by a Peltier element. If a limit temperature is exceeded, the NAD area may be cooled by the/a Peltier element and the/a forced airflow.

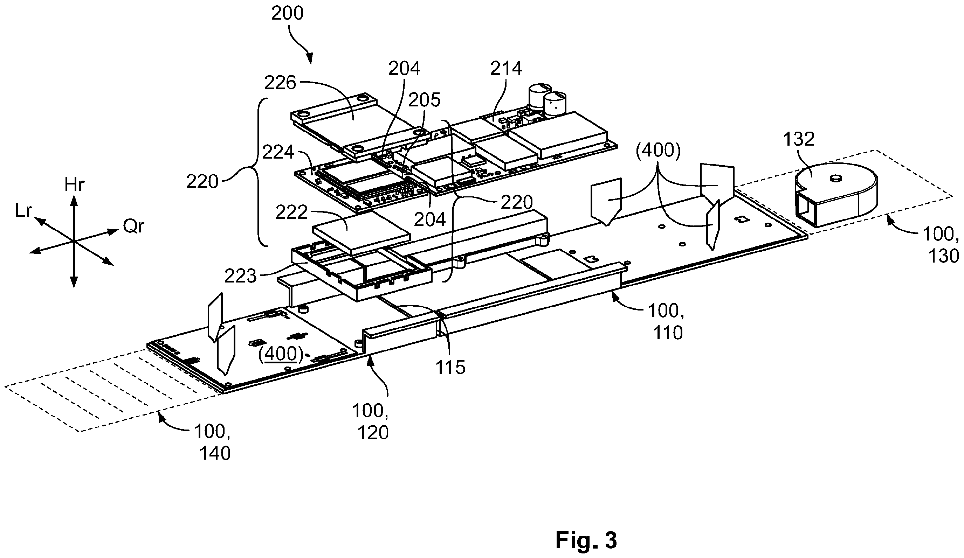

In embodiments, heat of the non-NAD area may be transported out of the vehicle-body antenna module by the forced airflow (see arrows (airflow) in Figure 3) in the transverse direction. - Furthermore, heat of the Peltier element may be transported out of the vehicle-body antenna module by the forced airflow in the transverse direction. This heat flow is relatively small in comparison to the heat flow of the Peltier element which may be dissipated to the vehicle body (see arrow (heat flow) in Figure 5). In addition, heat of the Peltier element may be dissipated to a body of the vehicle, preferably via a lower housing or a base plate of the vehicle-body antenna module. This heat flow is relatively large in comparison to the heat flow of the Peltier element, which may be transported away by the forced airflow.

Preferably, (intelligent) thermal software controls/regulates the fan, the Peltier element, and/or the telematics printed circuit board, in order to avoid thermal failures and/or damage to the electronics. At least one temperature sensor forms a starting point for thermal management by means of the thermal software. The relevant limit temperature may be measured at/in at least one critical electronic component, in particular the telematics printed circuit board. Furthermore, the relevant limit temperature may be measured outside on and/or inside in the non-NAD area, and/or outside on and/or inside in the NAD area. Furthermore, the relevant limit temperature may be measured at at least one point on the/a base plate, in the vicinity of the Peltier element etc.

In an overall concept, for example, thermal management may be used, by means of which the following possible scenarios may be applied, as a function of a single limit temperature or several limit temperatures, possibly taking the outside temperature into consideration. - Scenario a: the fan is inactive and the Peltier element is inactive; scenario b: the fan is active (with control/regulation of the airflow or the cooling) and the Peltier element is inactive; scenario c: the fan is active (with/without control/regulation of the airflow or the cooling) and the Peltier element is active (with/without control/regulation of the power); and/or scenario d: the fan is inactive and the Peltier element is active (with/without control/regulation of the power).

In the cooling method, if a limit temperature is exceeded inside the antenna module, possibly even in the case of active cooling, at least one affected component of the antenna module may not be operated. The antenna module may be configured as a vehicle-body antenna module according to the present invention, in particular a 5G antenna module.

At very low temperatures, for example, below -25°C to below -35°C, in particular below - 40°C, the following scenario e is still also applicable. Since performance of the NAD area is possibly not ideal or not given at such temperatures, the NAD area may be brought into a better or ideal temperature range via heating. That is, by electrically reversing the polarity of the Peltier element, the Peltier element may be used for heating the NAD area.

The vehicle body according to the present invention or the vehicle according to the present invention comprises a vehicle-body antenna module according to the present invention, in particular a 5G antenna module according to the present invention. Furthermore, by means of the vehicle according to the present invention, a method according to the present invention for cooling a vehicle-body antenna module, in particular a 5G antenna module, may be carried out. The cooling method may be carried out by means of an internal control unit of the antenna module or possibly a control unit of the vehicle, which, of course, may also assume other tasks.

The present invention will be described below in greater detail with the aid of exemplary embodiments, making reference to the attached schematic drawing, which is not to scale. Sections, elements, parts, units, components, and/or schemes which have an identical, univocal, or analogous configuration and/or function, are indicated in the description of the figures (see below), the list of reference signs, the patent claims, and in the figures of the drawing having the same reference signs. A possible alternative which is not described in the description of the present invention (see above), which is not depicted in the drawing, and/or which is not conclusive, a static and/or kinematic reversal, a combination, etc., with respect to the exemplary embodiments of the present invention or a component, a diagram, a unit, a part, an element, or a section thereof, may furthermore be removed from the list of reference signs and/or the description of the figures.

In the present invention, a feature (section, element, part, unit, component, function, dimension, etc.) may be designed positively, i.e. being present, or negatively, i.e. being absent. In this specification (description (description of the present invention (see above), description of the figures (see below)), list of reference signs, patent claims, drawing) a negative feature is not explicitly described as a feature unless, according to the present invention, importance is placed on it being absent. That is, the invention which is actually made, and not an invention which is constructed by the prior art, is to omit this feature.

A feature of this specification may be used not only in a specified way, but also in another way and/or manner (isolation, summary, replacement, addition, unique position, omission, etc.). In particular, on the basis of a reference sign and a feature associated with it, or vice versa, it is possible to replace, add, or omit a feature in the patent claims and/or the description in the description, the list of reference signs, the patent claims, and/or the drawing. In addition, a feature in a patent claim may thereby be interpreted and/or specified in greater detail.

The features of the description may be interpreted as optional features (in the view of the (initially mostly unknown) prior art), i.e. each feature may be comprehended as an optional, arbitrary, or preferred feature, i.e. as a non-binding feature. Thus, an extraction of a feature, possibly including its periphery, from an exemplary embodiment is possible, wherein this feature is then transferable to a generalized inventive idea. The absence of a feature (negative feature) in an exemplary embodiment indicates that the feature is optional with respect to the present invention. Furthermore, in the case of a species term for a feature, a generic term may also be read for the feature (possibly further hierarchical breakdown into subgenus, etc.), whereby, for example, a generalization of the feature is possible, taking equal effect and/or equivalence into consideration.

In the figures, which are merely exemplary, the following are shown:
Figure 1 depicts a perspective view of an embodiment of a vehicle-body antenna module according to the present invention, which is not specified in greater detail, for a motor vehicle,
Figure 2 depicts a three-dimensional exploded view of a further embodiment of such an antenna module according to the present invention,
Figure 3 depicts a three-dimensional exploded view of an arrangement according to the present invention of a lower housing and a telematics unit of an embodiment of the antenna module according to the present invention,
Figure 4 depicts a top view of the arrangement according to the present invention of the lower housing and the telematics unit from Figure 3, in an assembled state,
Figure 5 depicts a sectional view in the longitudinal direction and vertical direction through the arrangement of the lower housing and the telematics unit from Figure 4, in a recess of a vehicle body of a motor vehicle,
Figure 6 depicts a top view of a telematics printed circuit board according to the present invention for the telematics unit according to the present invention, comprising a head, a neck, and a torso, and
Figure 7 depicts a schematic block diagram of a generalized principle of a cooling system according to the present invention for the antenna module.

The present invention is explained below with the aid of exemplary embodiments of an embodiment of a variant of a vehicle-body antenna module 10, in particular a 5G antenna module 10, in connection with a method (see above) for cooling such an antenna module, for a vehicle, in particular a motor vehicle. Although the present invention is described and illustrated in greater detail by means of preferred exemplary embodiments, the present invention is not limited by the disclosed exemplary embodiments, but is of a more fundamental nature.

Other variations may be derived from this and/or from the above (description of the present invention) without departing from the protective scope of the present invention. The present invention is generally applicable in the field of vehicle antennas, in particular in external (not depicted) or integrated roof antenna modules for motor vehicles. The drawing depicts only the spatial sections of an object of the present invention which are necessary for understanding the present invention.

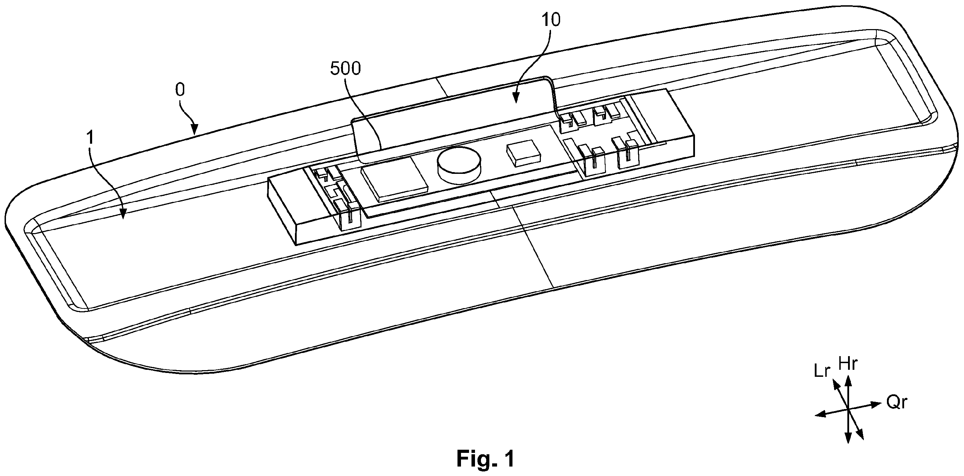

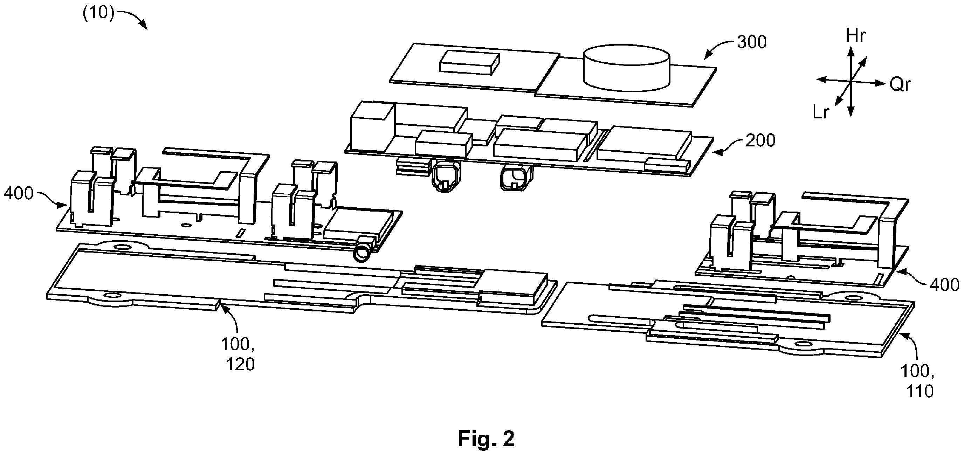

Figures 1 and 2 depict two general structures of integrated antenna modules 10, wherein, in Figure 1, the antenna module 10 is arranged in a recess 1, in particular a depression 1, of a vehicle body 0, in particular of a rear end 0 or a roof 0 (front, centre, rear). Very generally approximately, the antenna module 10 has the shape of a prismatoid, in particular approximately or essentially the shape of a cuboid, having a comparatively long transverse extension (in the transverse direction Qr of the vehicle or antenna module 10), and a length (in the longitudinal direction Lr of the vehicle or antenna module 10) which is preferably greater than its height (in the vertical direction Hr of the vehicle or antenna module 10).

Such an antenna module 10 depicted in Figures 1 and 2 comprises, for example, a lower housing 100, a telematics unit 200 (TCU: telematics control unit), possibly another circuit board 300, for example, an antenna support 300, in particular for satellite services, possibly at least one antenna support 400, and an upper housing 500. In the event that the other printed circuit board 300 is provided, it is preferably mounted in the upper housing 500.

According to the present invention, see Figures 3 to 6, the telematics unit 200 comprises a telematics printed circuit board 202, in addition to a cooling device 222, 223, 226, 228. The telematics printed circuit board 202 (see in particular Figure 6) is divided into two sections 214, 224, wherein the first section 214 is configured as a non-NAD area 214, and the second section 224 is configured as a NAD area 224. Preferably, an outer shape, i.e. an outer contour of an actual printed circuit board of the telematics printed circuit board 202, is formed at least in sections mirror-symmetrically with respect to a central transverse axis Qr of the telematics printed circuit board 202. In particular, the non-NAD area 214 and/or the NAD area 224 is mirror-symmetric in this manner.

The telematics printed circuit board 202 comprises a thermal barrier arrangement 204, for example, at least one through-slit 204, between the non-NAD area 214 and the NAD area 224. Presently, the thermal barrier arrangement 204 comprises two through-slits 204, 204, which mirror-symmetrically divide the telematics printed circuit board 202 into a head 224, neck 205, and torso 214 (Figure 6), with respect to the central transverse axis Qr. The remaining neck 205, being a constriction, is designed in such a way that a signal exchange between the head 224 and the torso 214 is ensured, but any other (heat-conducting) material between the head 224 and the torso 214 is primarily or essentially removed.

A transceiver module for mobile communication (NAD) is preferably situated on an upper side of the telematics printed circuit board 202 (see Figure 3). There are several technical reasons for this. The transceivers themselves are supplied as separate modules which comprise a printed circuit board, ICs soldered onto it, and a protective cage. The best heat dissipation is achieved via the printed circuit board of the module (lowest thermal resistance), i.e. the telematics printed circuit board 202. Heat dissipation via the protective cage is often significantly less effective. The best connection of a heat exchanger, i.e. the Peltier element 222, is therefore through the path of the telematics printed circuit board 202, which carries the transceiver module and other electronic components.

According to the present invention (see Figures 3 to 5), if a limit temperature is exceeded at/in the antenna module 10, the first section 214 of the telematics printed circuit board 202 or the non-NAD area 214, and the second section 224 of the telematics printed circuit board 202 or the NAD area 224, are actively cooled, wherein the first section 214 or the non-NAD area 214, and the second section 224 or the NAD area 224, can be cooled essentially independently of one another.

Preferably, the first section 214 of the telematics printed circuit board 202 or the non-NAD area 214 is cooled by a forced airflow, and the second section 224 of the telematics printed circuit board 202 or the NAD area 224 is cooled by a Peltier element 222 (TEC (thermoelectric cooler) element 222). The forced airflow may preferably be generated by a fan 132, in particular a centrifugal fan 132. - For the temperature control, for example, of thermal management by means, for example, of thermal software, see above.

Furthermore, the telematics unit 200 may be divided into two areas 214, 220. The first area 214 is essentially identical to the first section 214 of the telematics printed circuit board 202 or the non-NAD area 214. The second area 220 of the telematics unit 200 comprises a cooling package 220 in which the NAD area 224 of the telematics printed circuit board 202 is arranged to be coolable. The orientations of the two areas 214, 220, i.e. an extent of the first area 214 (in the transverse direction Qr) and a stacking direction (sandwich) of the second area 220 (in the vertical direction Hr), are preferably primarily or essentially perpendicular to one another. - In addition, the airflow which is forceable by the fan 132 may be directed onto the cooling package 220.

With reference to Figure 3 from bottom to top, the cooling package 220 comprises an accommodation frame 223 in which the Peltier element 222 may be accommodated. Furthermore, the NAD area 224 may be accommodated on the Peltier element 222 in the accommodation frame 223, wherein they are in good heat-transfer contact. The cooling package 220 is closable at the top preferably by a cooling package cover 226 which may be situated on the NAD area 224 or may be arranged at a distance (air gap) therefrom.

The first area 214 or the non-NAD area 214 is preferably arranged in good heat-transfer contact on the lower housing 100, in particular a first (lower housing) base plate 110. - The second area 224 or the NAD area 224 or the cooling package 220 or the Peltier element 222 and possibly the accommodation frame 223 is preferably arranged in good heat-transfer contact on the lower housing 100, in particular a second (lower housing) base plate 120. - Preferably, the first base plate 110 and the second base plate 120 are arranged spaced with respect to one another in the antenna module 10 via a thermal barrier 115 configured, for example, as an air slit 115.

The Peltier element 222 is arranged in the cooling package 220 in such a way, or is actuated for cooling the second area 220 or the NAD area 224 in such a way, that the hot side thereof is situated at the second base plate 120, and the cold side thereof is situated at the NAD area 224. In particular, good heat-transfer contact is established in each case.

At least beneath the second base plate 120, in particular beneath both bottom plates 110, 120, i.e. on outer surface of the antenna module 10, a heat-transfer device 102, for example, a thermally conductive pad 102, is arranged, which may be provided on the vehicle body 0 and, for example, in the recess 1, for establishing good heat-transfer contact. That is, the antenna module 10 is configured in such a way that the vehicle body 0 of the vehicle or the vehicle functions as a substantial heat sink.

The Peltier element 222 or the cold side of the Peltier element 222, the accommodation frame 223, and the cooling package cover 226 define a more or less sealed cooling space 228, depending on the design effort carried out for the sections involved, including the telematics printed circuit board 202 in the area of its narrow point 202. Here, the NAD area 224 is situated inside, and the non-NAD area 214 is situated outside, the cooling space 228 of the cooling packet 200 of the telematics unit 200.

An antenna support 400 may be provided on the first base plate 110 and/or the second base plate 120. Here, the forceable airflow may be directed onto this at least one antenna support 400. Adjacent, in a respective transverse direction Qr, a respective (lower housing) side end portion 130, 140 may connect to one or both bottom plates 110, 120. The fan 132 may be mounted, for example, on an air intake of the side end portion 130. Furthermore, the other side end portion 140 may comprise an air outlet.

The telematics unit 200 presently comprises not only a transceiver (transceiver module), but preferably further components, for example, WLAN/BT/BTLE, a receiver for GNSS, Gyro, audio amplifier for eCall, CAN transceiver, Ethernet transceiver, and/or at least one microcontroller, etc. Thus, it is a preferably complete telematics unit 200 and not just a transceiver or an IC. In contrast to a transceiver, these additional electronics can handle higher temperatures and do not require sophisticated cooling; a fan is sufficient here.

However, additional electronics must be prevented, to the greatest possible extent, from heating up the transceiver module even further. Otherwise, the Peltier element 222 would be further loaded with heat and would possibly cause a thermal short circuit. Thus, it is necessary to create a kind of island (peninsula) (transceiver module, NAD area 224) having as little connection as possible between these two sections (non-NAD area 214 and transceiver module or NAD area 224). Here, it may be necessary to insulate the transceiver thermally in the cooling package 220. By means of a lateral arrangement of the fan, the air is able to cool the electronics, and simultaneously cools the cooling package 220. Thus, there is a combination of two different sections or areas to be cooled in one cooling concept.

In principle, a transceiver usually works ideally only in a certain defined temperature range. By means of cooling and possibly heating, according to the present invention, it is attempted to be able to operate the transceiver in this range for as long as possible. But if a temperature rises still further, it is not just performance alone which is important, but rather, basic functionality must still be provided, in order, for example, to be able to trigger an eCall in the case of emergency. In such a case, eCall capability must be ensured. Accordingly, the antenna module 10 is to be actuated or partially switched on in order not to create even more heat.

Of course, according to the present invention, it is possible to push the isolation so far that the non-NAD area 214 and the transceiver module or the NAD area 224 are arranged separately from one another in the antenna module 10. This is depicted in the schematic block diagram in Figure 7 (no intrinsic connection between the non-NAD area 214 and the NAD area 224). The arrows at the top indicate an airflow from the fan 132 across the non-NAD area 214, and the arrow at the bottom indicates a heat flow from the Peltier element 22 into the vehicle body 1.

### List of Reference Signs

- 0: Vehicle body

- 1: Recess

- 10: Vehicle-body antenna module

- 100: Lower housing
- 102: Heat-transfer arrangement
- 110: (First) (lower housing) base plate for cooling the non-NAD area 214
- 115: Thermal barrier
- 120: (Second) (lower housing) base plate for cooling the NAD area 224 or the cooling package 220 or the Peltier element 222
- 130: (First) (lower housing) side end portion
- 132: Fan
- 140: (Second) (lower housing) side end portion
- 200: Telematics unit
- 202: Telematics printed circuit board
- 204: Thermal barrier device
- 205: Narrow point
- 214: (First) area of the telematics unit 200 and (first) section of the telematics printed circuit board 202, non-NAD area
- 220: (Second) area of the telematics unit 200, cooling package
- 222: Peltier element
- 223: Accommodation frame
- 224: (Second) section of the telematics printed circuit board 202, NAD area
- 226: Cooling package cover
- 228: Cooling space
- 300: Antenna support
- 400: Antenna support
- 500: Upper housing

- Hr: Vertical direction of antenna module 10
- Lr: Transverse direction of antenna module 10
- Qr: Transverse direction of antenna module 10

## Claims

1. Vehicle-body antenna module (10), in particular 5G antenna module (10), for a vehicle, in particular a motor vehicle, comprising
at least: a lower housing (100), a telematics unit (200), and an antenna support (400), wherein the antenna module (10) extending primarily in a transverse direction (Qr) is configured in such a way that a telematics printed circuit board (202) of the telematics unit (200) is actively coolable, **characterized in that**
a first section (214) of the telematics unit (200) or the telematics printed circuit board (202) is coolable by a forced airflow, and a second section (224) of the telematics unit (200) or the telematics printed circuit board (202) is coolable by a Peltier element (222) .

2. Vehicle-body antenna module (10) according to the preceding claim, **characterized in that**:
• the first section (214) is configured as a non-NAD area (214), and the second section (224) as a NAD area (224), of the telematics printed circuit board (202),
• the telematics printed circuit board (202) comprises a thermal barrier arrangement (204) between the NAD area (224) and the non-NAD area (214) for decoupling a mutual heat exchange, and/or
• the/a thermal barrier arrangement (204) comprises two through-slits (204, 204) in the telematics printed circuit board (202), which divide the telematics printed circuit board (202) preferably: into a head (224), neck (205), and torso (214).

3. Vehicle-body antenna module (10) according to one of the preceding claims, **characterized in that**:
• the antenna module (10) is configured in such a way that a body of the motor vehicle acts as a substantial heat sink for the antenna module (10),
• the antenna module (10) is configured in such a way that heat from the telematics unit (200) can be transferred to the/a vehicle body via its lower housing (100), and/or
• the antenna module (10) comprises a fan (132) in a transverse end section, wherein the airflow which is forceable by said fan (132) is directed at least onto the first section (214) of the telematics printed circuit board (202).

4. Vehicle-body antenna module (10) according to one of the preceding claims, **characterized in that** the telematics unit (200) comprises areas (214, 220), wherein:
• the first area (214) of the telematics unit (200) corresponds to the/a non-NAD area (214) of the telematics printed circuit board (202),
• the second area (220) of the telematics unit (200) comprises a cooling package (220) in which the/a NAD area (224) of the telematics printed circuit board (202) is arranged to be coolable, and/or
• at least one area (214/220) or both areas (214, 220) of the telematics unit (200) are in heat-transfer contact with the lower housing (100).

5. Vehicle-body antenna module (10) according to one of the preceding claims, **characterized in that**:
• the second section (224) of the telematics printed circuit board (202) is arranged in the/a cooling package (220) of the telematics unit (200),
• the cooling package (220) comprises the Peltier element (222), the NAD area (224) of the telematics printed circuit board (202), and preferably a cooling package cover (226), and/or
• the cooling package (220) further comprises an accommodation frame (223) in which the Peltier element (222) and the NAD area (224) may be accommodated, wherein the accommodation frame (223) is preferably closable by the cooling package cover (226).

6. Vehicle-body antenna module (10) according to one of the preceding claims, **characterized in that**:
• the NAD area (224) is in heat-transfer contact with a cold side of the Peltier element (222),
• the cooling package (220) has a sandwich structure, in which the package components thereof are arranged stacked in the vertical direction (Hr) of the antenna module (10), and/or
• the airflow which is forceable by the fan (132) is further directed to the cooling package (220) of the telematics unit (200).

7. Vehicle-body antenna module (10) according to one of the preceding claims, **characterized in that** the lower housing (100) comprises at least one or exactly one base plate, wherein:
• a first section of the base plate is in heat-transfer contact with the non-NAD area (214),
• a second section of the base plate is in heat-transfer contact with the cooling package (220), in particular a hot side of the Peltier element (222), and/or
• for decoupling a mutual heat exchange, the base plate comprises a thermal barrier arrangement between its first section and its second section.

8. Vehicle-body antenna module (10) according to one of the preceding claims, **characterized in that** the lower housing (100) comprises at least or exactly two bottom plates (110, 120), wherein:
• the first base plate (110) is in heat-transfer contact with the non-NAD area (214),
• the second base plate (120) is in heat-transfer contact with the cooling package (220), in particular a hot side of the Peltier element (222), and/or
• for decoupling a mutual heat exchange, the two bottom plates (110, 120) are arranged spaced apart from one other in the antenna module (10) via a thermal barrier slit (115).

9. Vehicle-body antenna module (10) according to one of the preceding claims, **characterized in that**:
• at least one or one respective antenna support (400) is arranged on the first (110) and/or second base plate (120),
• the airflow which is forceable by the fan (132) is further directed onto at least one antenna support (400),
• the lower housing (100) comprises a side end portion (130) in a transverse end section, on which the fan (132) is mounted, and/or
• the lower housing (100) comprises a side end portion (140) in a transverse end section, which comprises an air outlet.

10. Vehicle-body antenna module (10) according to one of the preceding claims, **characterized in that**:
• the lower housing (100) is configured in such a way that it is connectable to the vehicle body (1) in an areal manner,
• the lower housing (100) comprises a heat-transfer device (102), in particular a thermally conductive pad, on its outer surface,
• the antenna module (10) itself is free of a separate heat sink, in particular a separate finned heat sink,
• the antenna module (10) comprises another printed circuit board (300) between the lower housing (100), in particular the telematics unit (200), and an upper housing (500),
• a maximum height of the antenna module (10) is: approximately: 50 mm, 45 mm, 40 mm, 35 mm, 32.5 mm, 30 mm, 27.5 mm, 25 mm, 22.5 mm, 20 mm, 17.5 mm, or 15 mm, and/or
• by means of the antenna module (10), a method for cooling a vehicle-body antenna module (10), in particular a 5G antenna module (10), may be carried out according to one of the subsequent claims.

11. Method for cooling a vehicle-body antenna module (10), in particular a 5G antenna module (10), of a vehicle, in particular a motor vehicle, wherein
the antenna module (10) comprises a telematics unit (200) including a telematics printed circuit board (202), wherein the telematics unit (200) or the telematics printed circuit board (202) is divided into a non-NAD area (214) and a NAD area (224), **characterized in that**
if a limit temperature is exceeded, the non-NAD area (214) and/or the NAD area (224) are actively cooled, and the non-NAD area (214) and the NAD area (224) can be essentially cooled independently of one another.

12. Cooling method according to the preceding claim, **characterized in that**:
• if a limit temperature is exceeded, the non-NAD area (214) is cooled by a forced airflow of a fan (132),
• if a limit temperature is exceeded, the NAD area (224) is cooled by a Peltier element (222), and/or
• if a limit temperature is exceeded, the NAD area (224) is cooled by the/a Peltier element (222) and the/a forced airflow.

13. Cooling method according to one of the preceding claims, **characterized in that**:
• heat of the non-NAD area (214) is transported out of the vehicle-body antenna module (10) by the forced airflow in the transverse direction (Qr),
• heat of the Peltier element (222) is transported out of the vehicle-body antenna module (10) by the forced airflow in in the transverse direction (Qr), and/or
• heat of the Peltier element (222) is dissipated to a body (0) of the vehicle, preferably via a lower housing (100) or a base plate (120) of the vehicle-body antenna module (10).

14. Cooling method according to one of the preceding claims, **characterized in that** the relevant limit temperature:
• is measured at/in at least one critical electronic component, in particular the telematics printed circuit board (202),
• is measured outside on and/or inside in the non-NAD area (214), and/or outside on and/or inside in the NAD area (224),
• if a limit temperature is exceeded inside the antenna module (10), even in the case of active cooling, at least one affected component of the antenna module (10) is not operated, and/or
• the antenna module (10) is configured as a vehicle-body antenna module (10), in particular a 5G antenna module (10), according to one of the preceding claims.

15. Vehicle body (0) for a vehicle, in particular a motor vehicle, or vehicle, in particular motor vehicle, **characterized in that**
the vehicle body (0) or the vehicle comprises a vehicle-body antenna module (10), in particular a 5G antenna module (10), according to one of the preceding claims, and/or
by means of the vehicle, a method for cooling a vehicle-body antenna module (10), in particular a 5G antenna module (10), may be carried out according to one of the preceding claims.
